(19) Europäisches Patentamt
European Patent Office
Office européen des brevets

(11) **EP 3 975 063 A1**

(12) **EUROPEAN PATENT APPLICATION**

(43) Date of publication:
**30.03.2022 Bulletin 2022/13**

(21) Application number: **20198329.3**

(22) Date of filing: **25.09.2020**

(51) International Patent Classification (IPC):
**G06N 3/08** (2006.01)     **G06N 20/00** (2019.01)

(52) Cooperative Patent Classification (CPC):
**G06N 3/08; G06N 3/084; G06N 20/00**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Robert Bosch GmbH
70442 Stuttgart (DE)**
• **Technische Universität Darmstadt
64289 Darmstadt (DE)**

(72) Inventors:
• **Kandemir, Melih
70439 Stuttgart (DE)**

• **Peters, Jan
64342 Seeheim-Jugenheim (OT Malchen) (DE)**
• **Flynn, Hamish
70182 Stuttgart (DE)**

(74) Representative: **Bee, Joachim
Robert Bosch GmbH
Zentralabteilung Patente
Postfach 30 02 20
70442 Stuttgart (DE)**

Remarks:
•Amended claims 1-14 in accordance with Rule 137(2) EPC.
•Amended claims 1-14 filed after the date of filing of the application (Rule 68(4) EPC).

(54) **DEVICE FOR AND COMPUTER IMPLEMENTED METHOD OF MACHINE LEARNING**

(57)     Device and computer implemented method of machine learning a model for mapping a dataset to a solution of a task depending on a first parameter, characterized by determining (204) a second parameter for assigning the second parameter to the first parameter in a first iteration of learning and determining (204) a third parameter for determining a rate for changing the first parameter in at least one iteration of learning depending on the third parameter and depending on a measure for evaluating the solution to the task, wherein determining (204) the second parameter or third parameter comprises determining (204-2a) a solution of an initial value problem that depends on a derivative of the measure with respect to the first parameter, wherein determining (204-2a) the solution comprises determining a first part of the solution of the initial value problem depending on an initial value, determining a second part of the solution of the initial value problem depending on the first part, determining (204-2c) for the first part a partial derivative, determining (204-2c) for the second part a partial derivative, and determining (204-2d) the second parameter and/or the third parameter depending on at least one of the partial derivatives.

Fig. 2

**Description**

Background

The invention relates to a device for and a computer implemented method of machine learning in particular of a model.

In machine learning, a set of parameters of the model is determined in training iterations according to a learning rule. Gradient-based meta learning aims to adapt the learning rule to a set of related tasks. The learning rule describes how the set of parameters changes over training iterations.

Model Agnostic Meta Learning, MAML, is an example for gradient-based meta learning. An example for MAML is described in Model-Agnostic Meta-Learning for Fast Adaptation of Deep Networks, which is retrievable from https://arxiv.org/abs/1703.03400.

Gradient-based meta learning methods including MAML use variants of gradient descent to determine the learning rule.

Disclosure of the invention

The device for and computer implemented method of machine learning uses a learning rule that is a variant of a gradient flow. Gradient descent is a special case of gradient flow. Gradient flow is a gradient descent with infinitesimal step size, or equivalently, gradient descent in continuous-time. With gradient flow, the learning rule is given by an ordinary differential equation, ODE, that describes the change in the parameters of interest over time. Learning with gradient flow is an initial value problem, IVP, i.e. given an initial value for the parameters and an ODE describing the change in the parameters over time, compute the value of the parameters at some future time.

The computer implemented method of machine learning a model for mapping a dataset to a solution of a task depending on a first parameter comprises determining a second parameter for assigning the second parameter to the first parameter in a first iteration of learning and determining a third parameter for determining a rate for changing the first parameter in at least one iteration of learning depending on the third parameter and depending on a measure for evaluating the solution to the task, wherein determining the second parameter or third parameter comprises determining a solution of an initial value problem that depends on a derivative of the measure with respect to the first parameter, wherein determining the solution comprises determining a first part of the solution of the initial value problem depending on an initial value, determining a second part of the solution of the initial value problem depending on the first part, determining a partial derivative of the first part, determining a partial derivative of the second part, and determining the second parameter and/or the third parameter depending on at least one of the partial derivatives. This improves the performance of gradient-based meta learning significantly. This method directly improves a machine learning system. Given a set of machine learning tasks, the method aims to make a machine learning system better at learning to solve related tasks.

Preferably, the method comprises sampling the task from a distribution.

Preferably, the method comprises sampling a batch of tasks from the distribution, determining a plurality of partial derivatives for the batch of tasks, and determining the second parameter and/or the third parameter depending on the plurality of partial derivatives.

Preferably, the method comprises determining the partial derivatives with respect to the first parameter, and determining a change of the second parameter depending on a function of the partial derivatives, or determining the partial derivative with respect to the third parameter and determining a change of the third parameter depending on a function of the partial derivatives.

Preferably, determining the second parameter comprises randomly initializing the initial value in a first step of a plurality of steps of solving the initial value problem.

Preferably, the third parameter is initialized in the first step of the plurality of steps as a positive scalar or a vector or matrix of positive scalars.

Preferably, determining the solution of the initial value problem comprises solving the initial value problem with an ordinary differential equation solver according to an explicit Runge-Kutta method, in particular other than the Euler method. Gradient descent is recovered if Euler's method with step size 1 is used to solve this IVP. However, Euler's method is a very basic ODE solver and so it is unlikely to accurately follow the dynamics specified by the learning rule. On the other hand, if a more accurate ODE solver is used to solve the IVP, then the learning rule will be followed more accurately. The idea is that, since the solution to the IVP given by a more accurate ODE solver will follow the learning rule more accurately, it can give more accurate feedback on how the learning rule should be adapted.

Preferably, the method comprises determining for the task a plurality of parts of the solution of the initial value problem including the first part and the second part, and storing at least a part of the plurality of parts in memory.

Preferably, determining the plurality of partial derivatives for the task depending on the plurality of parts of the solution of the initial value problem comprises reading a first subset of the plurality of parts of the solution of the initial value problem from memory and determining a second subset of the plurality of parts of the solution of the initial value problem depending on at least one part of the solution of the initial value problem of the first subset. This applies gradient checkpointing for increased memory efficiency. An example of gradient checkpointing is described in Achieving Logarithmic Growth Of Temporal And Spatial Complexity In Reverse Automatic Differentiation which is retrievable from https://www.researchgate.net/publication/2550794 Achieving Logarithmic Growt h Of Temporal And Spatial Complexity In Reverse Automatic Differentiation

Preferably, the rate is defined depending on an ordinary differential equation comprising a derivative of a temporal course of the first parameter with respect to time and a partial derivative of a temporal course of the measure with respect to the temporal course of the first parameter.

Preferably, the method comprises determining in iterations different second parameter and/or third parameter for different batches of tasks sampled from the distribution, wherein the method comprises changing the first parameter after at least one of the iterations according to the second parameter and/or third parameter of the at least one of the iterations.

The method may comprise assigning the second parameter to the first parameter in a first iteration, determining the rate for changing the first parameter in the iteration depending on the third parameter, and changing the first parameter in the first iteration and/or a second iteration after the first iteration with the rate.

The device for machine learning the model is configured to perform steps in the method.

Further advantageous embodiments are derivable from the following description and the drawing. In the drawing:

Fig. 1    depicts a device for machine learning schematically,
Fig. 2    depicts steps in a computer implemented method of machine learning,
Fig. 3    depicts the device in an environment.

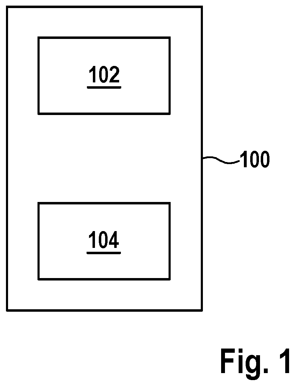

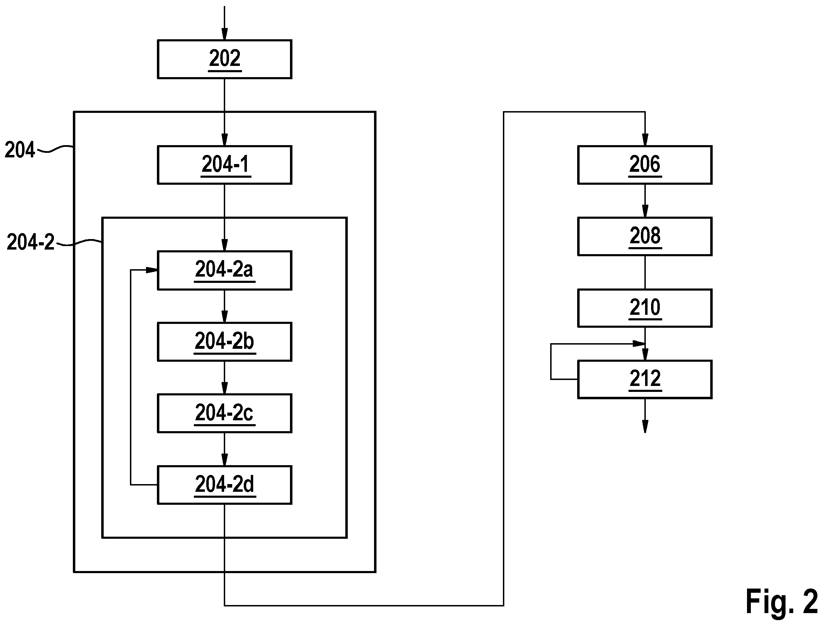

Figure 1 depicts a device 100 for machine learning schematically. The device 100 comprises at least one processor and at least one memory. Figure 1 depicts an example with a processor 102 and a memory 104. The memory 104 is configured to store computer readable instructions, that when executed by the processor 102, cause the processor 102 to execute steps of a computer implemented method that will be described with reference to figure 2 below.

The method is described for a model $f(x, \theta)$ for mapping a dataset $x$ to a solution of a task $\tau_i$ depending on a first parameter $\theta$. The task $\tau_i$ defines a dataset $x$ or a means for sampling the dataset $x$. The task $\tau_i$ defines a measure $L$ for for evaluating the solution to the task $\tau_i$. The measure $L$ may be a norm for evaluating a difference of the solution to the task $\tau_i$ to a reference. The norm is for example a mean square error. For example, measure $L$ could be the square of the distance between a prediction and a target. The measure $L^{(i)}$ may be a performance measure for task $\tau_i$. It may be a loss function that takes a prediction made by the model $f(x, \theta)$ and may return a scalar value. The goal of task $\tau_i$ may be stated as: maximize/minimize the measure $L^{(i)}$. In one example, the tasks $\tau_i$ from the task distribution $q(\tau)$ have the same loss function, i.e. $L^{(i)} = L$ for every i.

The method comprises a step 202 of providing a task distribution $p(\tau)$, the model $f(x; \theta)$ with first parameters $\theta$, second parameters $\theta_0$ and a learning rule defining a rate $\dfrac{d\theta}{dt} = g\left(\dfrac{dL}{d\theta}, \theta, t; \gamma\right)$ of change for the first parameters $\theta$ depending on third parameters y.

The learning rule may define the rate in terms of a function of a derivative of the measure $L$ e.g. with a scalar third parameter $\gamma$

$$g\left(\frac{dL}{d\theta}, \theta, t; \gamma\right) = -\gamma \frac{dL}{d\theta}$$

or as a vector or matrix of such third parameter $\gamma$

$$g\left(\frac{dL}{d\theta}, \theta, t; \gamma\right) = -diag(\gamma) \frac{dL}{d\theta}$$

The learning rule defines the rate depending on an ordinary differential equation, ODE.

In the example, the ODE is

EP 3 975 063 A1

$$\frac{d\theta(t)}{dt} = -\gamma \frac{\partial L^{(i)}\left(x^{(i)}, \theta(t)\right)}{\partial \theta(t)}$$

The ordinary differential equation comprises a derivative of a temporal course of the first parameter $\theta(t)$ with respect to time $t$ and a partial derivative of a temporal course of the measure $L^{(i)}(x^{(i)}, \theta(t))$ for the task $\tau_i$ with respect to the temporal course of the first parameter $\theta(t)$.

The method comprises a step 204 of meta learning.

Meta learning comprises determining in iterations different second parameter $\theta_0$ and/or third parameter $\gamma$ for different batches of tasks $\tau_1, \tau_2, ..., \tau_n \sim p(\tau)$ that are sampled from the distribution $p(\tau)$.

The method may comprises changing the first parameter $\theta$ after at least one of the iterations according to the second parameter $\theta_0$ and/or third parameter $\gamma$ of the at least one of the itrations.

For an iteration of meta learning, the method comprises a step 204-1 of sampling a batch of tasks $\tau_1, \tau_2, ..., \tau_n \sim p(\tau)$ from the task distribution $p(\tau)$.

For a tasks $\tau_i$ of the batch of tasks $\tau_1, \tau_2, ..., \tau_n \sim p(\tau)$ the method comprises a step 204-2 of task learning.

The step 204-2 comprises performing T steps 204-2a of solving an IVP. In an example the initial value problem is

$$\theta(T)^{(i)} = \theta(0) + \int_0^T g\left(\frac{dL^{(i)}}{d\theta}, \theta, t; \gamma\right) dt$$

with a higher-order ODE solver than Euler's method.

The solution of the IVP depends on a derivative of the measure $L$ with respect to the first parameter $\theta$

$$\frac{dL^{(i)}}{d\theta}$$

Determining the solution comprises determining a first part of the solution of the initial value problem depending on an initial value $\theta(0)$. The initial value $\theta(0)$ may be randomly initialized in a first step of the plurality $T$ of steps for the tasks $\tau_i$. The third parameter $\gamma$ is initialized in the first step of the plurality $T$ of steps as a positive scalar or a vector or matrix of positive scalars. In an example, the scalar is e.g. 0.01.

For the task $\tau_i$ the initial value is $\theta(0)^{(i)}$. When two steps are used, i.e for $T = 2$, this corresponds to $\theta(T-1)^{(i)}$.

Determining the solution comprises determining a second part of the solution of the initial value problem depending on the first part.

When two steps are used, i.e. for $T = 2$ the second part of the solution is $\theta(1)^{(i)}$ and corresponds to $\theta(T)^{(i)}$.

For two tasks, i.e. for $i = 2$, and when the Euler method with a step size 1 is used to approximate the solution of the IVP, then the following T parts are calculated:

$$\theta(0)^{(1)} = \theta_0$$
$$\theta(1)^{(1)} = \theta(0)^{(1)} + g\left(\frac{dL^{(1)}}{d\theta(0)^{(1)}}, \theta(0)^{(1)}, 0; \gamma\right)$$
$$\vdots$$
$$\theta(T)^{(1)} = \theta(T-1)^{(1)} + g\left(\frac{dL^{(1)}}{d\theta(T-1)^{(1)}}, \theta(T-1)^{(1)}, T-1; \gamma\right)$$

$$\theta(0)^{(2)} = \theta_0$$

$$\theta(1)^{(2)} = \theta(0)^{(2)} + g\left(\frac{dL^{(2)}}{d\theta(0)^{(2)}}, \theta(0)^{(2)}, 0; \gamma\right)$$

$$\vdots$$

$$\theta(T)^{(2)} = \theta(T-1)^{(2)} + g\left(\frac{dL^{(2)}}{d\theta(T-1)^{(2)}}, \theta(T-1)^{(2)}, T-1; \gamma\right)$$

Here, $\theta^{(1)}(0)$, $\theta^{(1)}(1)$, ..., $\theta^{(1)}(T)$, $\theta^{(2)}(0)$, $\theta^{(2)}(1)$, ..., $\theta^{(2)}(T)$ are all intermediate values in a calculation of a meta loss $L_{meta}$.

In one example a plurality of parts of the solution of the IVP including the first part and the second part are calculated for the task $\tau_i$.

The solution of the IVP may be determined with an ordinary differential equation solver according to an explicit Runge-Kutta method, in particular other than the Euler method.

The step 204-2 comprises a step 204-2b of computing the meta loss

$$L_{meta} = \sum_i L^{(i)}\left(\theta(T)^{(i)}\right)$$

The meta loss $L_{meta}$ is determined depending on the plurality of parts of the solution of the IVP for different task $\tau_i$ of the batch of tasks $\tau_1$, $\tau_2$, $\tau_n$.

In one aspect, at least a part of the plurality of parts is stored in memory. To save memory, a part of the plurality of parts is stored in memory and another part of the plurality of parts is used for determining the solution but not stored in memory for later usage.

In the example, the meta loss $L_{meta}$ is determined for the tasks $\tau_i$ of the batch of tasks $\tau_1$, $\tau_2$, , $\tau_n \sim p(\tau)$. This is referred to as a forward propagation.

The step 204-2 comprises a step 204-2c of computing partial derivatives of the meta loss $L_{meta}$ with respect to meta parameters. In the example, the second parameter $\theta_0$ and the third parameter $\gamma$ are the meta parameters. In the example the partial derivative of the meta loss $L_{meta}$ with respect to the second parameter $\theta_0$ is

$$\frac{dL_{meta}}{d\theta_0}$$

In one example, this can be determined by

$$\frac{\partial L_{meta}}{\partial \theta_0} = \frac{\partial L_{meta}}{\partial L^{(1)}(\theta^{(1)}(T))} \frac{\partial L^{(1)}(\theta^{(1)}(T))}{\partial \theta^{(1)}(T)} \frac{\partial \theta^{(1)}(T)}{\partial \theta^{(1)}(T-1)} \cdots \frac{\partial \theta^{(1)}(1)}{\partial \theta^{(1)}(0)} \frac{\partial \theta^{(1)}(0)}{\partial \theta_0}$$
$$+ \frac{\partial L_{meta}}{\partial L^{(2)}(\theta^{(2)}(T))} \frac{\partial L^{(2)}(\theta^{(2)}(T))}{\partial \theta^{(2)}(T)} \frac{\partial \theta^{(2)}(T)}{\partial \theta^{(2)}(T-1)} \cdots \frac{\partial \theta^{(2)}(1)}{\partial \theta^{(2)}(0)} \frac{\partial \theta^{(2)}(0)}{\partial \theta_0}$$

In the example the partial derivative of the meta loss $L_{meta}$ with respect to the third parameter $\gamma$ is

$$\frac{dL_{meta}}{d\gamma}$$

This is referred to backpropagation. In one aspect, this step may comprise reading the plurality of parts of the IVP from memory.

The backpropagation may use checkpointing.

This means that determining the plurality of partial derivatives for the task $\tau_i$ depending on the plurality of parts of the solution of the IVP comprises reading a first subset of the plurality of parts of the solution of the IVP from memory and determining a second subset of the plurality of parts of the solution of the IVP depending on at least one part of the solution of the IVP of the first subset.

This means, a plurality of partial derivatives is determined for the batch of tasks $\tau_1$, $\tau_2$, ..., $\tau_n$.

In one aspect, the partial derivatives are determined with respect to the first parameter $\theta$. In this aspect, a change of the second parameter $\theta_0$ is determined depending on a function, e.g. a sum, of these partial derivatives.

In one aspect, the partial derivatives are determined with respect to the third parameter $\gamma$. In this aspect, a change of the third parameter $\gamma$ is determined depending on a function, e.g. a sum, of these partial derivatives.

The step 204-2 comprises a step 204-2d of updating the meta parameters using these partial derivatives of $L_{meta}$, e.g. $\dfrac{dL_{meta}}{d\theta_0}$, $\dfrac{dL_{meta}}{d\gamma}$.

The second parameter $\theta_0$ is in one example determined depending on at least one of the partial derivatives with respect to the second parameter $\theta_0$. The third parameter $\gamma$ is in one example determined depending on at least one of the partial derivatives with respect to the third parameter $\gamma$.

The second parameter $\theta_0$ or the third parameter $\gamma$ may be determined depending on a plurality of partial derivatives.

The method comprises a step 206 of returning the adapted meta parameters. In the example, the second parameter $\theta_0$ and the third parameter $\gamma$ *are* returned.

The method may comprise a step 208 of determining the rate $\dfrac{d\theta}{dt} = g\left(\dfrac{dL}{d\theta}, \theta, t; \gamma\right)$ depending on the meta parameters, in the example the second parameter $\theta_0$ and the third parameter $\gamma$.

The method may end after the second parameter $\theta_0$ and/or the third parameter $\gamma$ are returned. The method may end after determining the rate $\dfrac{d\theta}{dt}$.

The method optionally comprises a step 210 and several iterations of a step 212.

The step 210 comprises assigning the second parameter $\theta_0$ to the first parameter $\theta$ in a first iteration t of learning.

The step 212 comprises changing the first parameter $\theta$ after the first iteration depending on the rate $\dfrac{d\theta}{dt} = g\left(\dfrac{dL}{d\theta}, \theta, t; \gamma\right)$.

The step 212 may be repeated for a fixed amount of iterations.

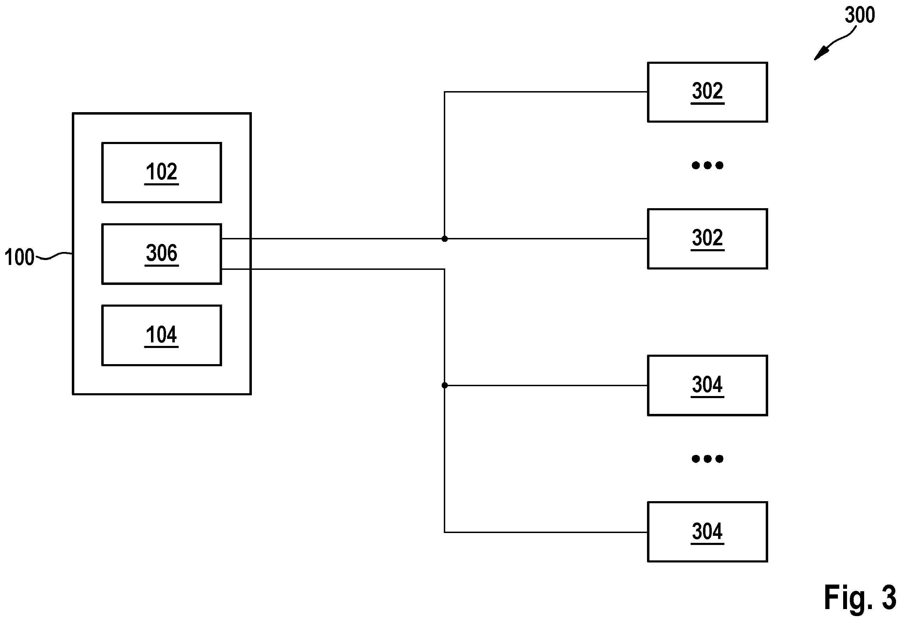

Figure 3 depicts the device 100 in an environment 300. The environment 300 comprises at least one sensor 302 and at least one actuator 304. The at least one sensor 304 in one example is configured to measure or detect physical or chemical characteristic of the environment 300. The at least one sensor 302 in one example is configured to output the dataset x or parts thereof depending on at least one physical or chemical characteristic of the environment 300 measured or detected by the at least one sensor 302. The at least one sensor 302 is in one example configured to output data for a measured or detected characteristic of one or more of the following types:

a digital image, e.g. video, radar, LiDAR, ultrasonic, motion, or thermal image of the environment 300 or a subject or object therein;
a scalar time series e.g. of a temperature in the environment 300 or another operating variables of a machine or another apparatus in the environment 300; an audio signal in the environment 300.

The processor 102 is in one example configured for classifying the data from the at least one sensor 302, for detecting a presence of objects in this data or for performing a semantic segmentation on this data, e.g. regarding traffic signs, road surfaces, pedestrians or vehicles in particular in the environment 300.

The processor 102 may be configured for supervised learning and reinforcement learning. The at least one processor 102 may be configured for an unsupervised anomaly detection setting. This means the processor 102 may be configured to detect anomalies. More specifically, the method described above may be used to adapt a learning strategy of an anomaly detection model to a given set of anomaly detection tasks. For example, suppose one had a set of related anomaly detection tasks, e.g. audio recordings from a set of somewhat related microphones, and an anomaly detection model, e.g. an autoencoder. Then the method is used to adapt the learning rule used to train this autoencoder such that it learns to detect anomalies in recordings from similar microphones faster and/or with greater sample-efficiency than it would otherwise.

The at least one actuator 304 is in one example configured to perform or cause an action in the environment 300. For example, the processor 102 is configured for classifying the data from the at least one sensor 302, for detecting the presence of objects and to control the action in the environment 300 according to a type or position of an object that is present in the environment 300. The device 100 may be configured to control an at least partial autonomous vehicle according to the type or position of the object.

The device 100 comprises in this aspect at least one interface 306 that is configured to interact with the at least one sensor 302 and/or the at least one actuator 304.

Likewise, the device may be adapted to compute a control signal for controlling any other physical system, like e.g. a computer-controlled machine, like a robot, a vehicle, a domestic appliance, a power tool, a manufacturing machine, a personal assistant or an access control system.

Likewise, the device may be adapted to compute a control signal for controlling a system for conveying information, like a surveillance system or a medical (imaging) system.

To this end, a suitable set of related tasks may be provided, e.g. by an expert. The method described above may be executed for this set of related tasks to improve the learning rule used by, for example, the computer-controlled machine or the surveillance system.

**Claims**

1. Computer implemented method of machine learning a model for mapping a dataset to a solution of a task depending on a first parameter, **characterized by** determining (204) a second parameter for assigning the second parameter to the first parameter in a first iteration of learning and determining (204) a third parameter for determining a rate for changing the first parameter in at least one iteration of learning depending on the third parameter and depending on a measure for for evaluating the solution to the task, wherein determining (204) the second parameter or third parameter comprises determining (204-2a) a solution of an initial value problem that depends on a derivative of the measure with respect to the first parameter, wherein determining (204-2a) the solution comprises determining a first part of the solution of the initial value problem depending on an initial value, determining a second part of the solution of the initial value problem depending on the first part, determining (204-2c) for the first part a partial derivative, determining (204-2c) for the second part a partial derivative, and determining (204-2d) the second parameter and/or the third parameter depending on at least one of the partial derivatives.

2. The method according to claim 1, **characterized by** sampling (204-1) the task from a distribution.

3. The method according to claim 2, **characterized by** sampling (204-1) a batch of tasks from the distribution, determining (204-2c) a plurality of partial derivatives for the batch of tasks, and determining (204-2d) the second parameter or the third parameter depending on the plurality of partial derivatives.

4. The method according to claim 2 or 3, **characterized by** determining (204-2c) the partial derivatives with respect to the first parameter, and determining (204-2d) a change of the second parameter depending on a function in particular a sum of the partial derivatives, or determining (204-2c) the partial derivative with respect to the third parameter and determining a change of the third parameter depending on a function in particular a sum of the partial derivatives.

5. The method according to one of the previous claims, **characterized in that** determining (204-2) the second parameter comprises randomly initializing the initial value in a first step of a plurality of steps of solving the initial value problem.

6. The method according to claim 5, **characterized in that** the third parameter is initialized in the first step of the plurality of steps as a positive scalar or a vector or matrix of positive scalars.

7. The method according to one of the previous claims, **characterized in that** determining (204-2) the solution of the initial value problem comprises solving the initial value problem with an ordinary differential equation solver according to an explicit Runge-Kutta method, in particular other than the Euler method.

8. The method according to one of the previous claims, **characterized by** determining (204-2a) for the task a plurality of parts of the solution of the initial value problem including the first part and the second part, and storing (204-2b) at least a part of the plurality of parts in memory.

9. The method according to claim 8, **characterized in that** determining the plurality of partial derivatives (204-2c) for the task depending on the plurality of parts of the solution of the initial value problem comprises reading a first subset of the plurality of parts of the solution of the initial value problem from memory and determining a second subset of the plurality of parts of the solution of the initial value problem depending on at least one part of the solution of the initial value problem of the first subset.

10. The method according to one of the previous claims, **characterized in that** the rate is defined depending on an ordinary differential equation comprising a derivative of a temporal course of the first parameter with respect to time and a partial derivative of a temporal course of the measure with respect to the temporal course of the first parameter.

11. The method according to one of the previous claims, **characterized by** determining in iterations different second parameter and/or third parameter for different batches of tasks sampled from the distribution, wherein the method comprises changing the first parameter after at least one of the iterations according to the second parameter and/or third parameter of the at least one of the iterations.

12. The method according to one of the previous claims, **characterized by** assigning the second parameter to the first parameter in a first iteration, determining the rate for changing the first parameter in the iteration depending on the third parameter, and changing the first parameter in the first iteration and/or a second iteration after the first iteration with the rate.

13. A device for machine learning a model, **characterized in that** the device is configured to perform steps in the method according to one of the claims 1 to 12.

14. A computer program, **characterized in that** the computer program comprises computer readable instructions, that cause a computer to perform steps in the method according to one of the claims 1 to 12 when the instructions are executed by the computer.


**Amended claims in accordance with Rule 137(2) EPC.**

1. Computer implemented method of machine learning a model for mapping a dataset to a solution of a task depending on a first parameter, wherein determining (204) a second parameter for assigning the second parameter to the first parameter in a first iteration of learning and determining (204) a third parameter for determining a rate for changing the first parameter in at least one iteration of learning depending on the third parameter and depending on a measure for for evaluating the solution to the task, **characterized by** determining (204) the second parameter or third parameter comprises determining (204-2a) a solution of an initial value problem that depends on a derivative of the measure with respect to the first parameter, wherein determining (204-2a) the solution comprises determining a first part of the solution of the initial value problem depending on an initial value, determining a second part of the solution of the initial value problem depending on the first part, determining (204-2c) for the first part a partial derivative, determining (204-2c) for the second part a partial derivative, and determining (204-2d) the second parameter and/or the third parameter depending on at least one of the partial derivatives.

2. The method according to claim 1, **characterized by** sampling (204-1) the task from a distribution.

3. The method according to claim 2, **characterized by** sampling (204-1) a batch of tasks from the distribution, determining (204-2c) a plurality of partial derivatives for the batch of tasks, and determining (204-2d) the second parameter or the third parameter depending on the plurality of partial derivatives.

4. The method according to claim 2 or 3, **characterized by** determining (204-2c) the partial derivatives with respect to the first parameter, and determining (204-2d) a change of the second parameter depending on a function in particular a sum of the partial derivatives, or determining (204-2c) the partial derivative with respect to the third parameter and determining a change of the third parameter depending on a function in particular a sum of the partial derivatives.

5. The method according to one of the previous claims, **characterized in that** determining (204-2) the second parameter comprises randomly initializing the initial value in a first step of a plurality of steps of solving the initial value problem.

6. The method according to claim 5, **characterized in that** the third parameter is initialized in the first step of the plurality of steps as a positive scalar or a vector or matrix of positive scalars.

7. The method according to one of the previous claims, **characterized in that** determining (204-2) the solution of the initial value problem comprises solving the initial value problem with an ordinary differential equation solver according to an explicit Runge-Kutta method, in particular other than the Euler method.

8. The method according to one of the previous claims, **characterized by** determining (204-2a) for the task a plurality of parts of the solution of the initial value problem including the first part and the second part, and storing (204-2b) at least a part of the plurality of parts in memory.

9. The method according to claim 8, **characterized in that** determining the plurality of partial derivatives (204-2c) for the task depending on the plurality of parts of the solution of the initial value problem comprises reading a first subset of the plurality of parts of the solution of the initial value problem from memory and determining a second subset of the plurality of parts of the solution of the initial value problem depending on at least one part of the solution of the initial value problem of the first subset.

10. The method according to one of the previous claims, **characterized in that** the rate is defined depending on an ordinary differential equation comprising a derivative of a temporal course of the first parameter with respect to time and a partial derivative of a temporal course of the measure with respect to the temporal course of the first parameter.

11. The method according to one of the previous claims, **characterized by** determining in iterations different second parameter and/or third parameter for different batches of tasks sampled from the distribution, wherein the method comprises changing the first parameter after at least one of the iterations according to the second parameter and/or third parameter of the at least one of the iterations.

12. The method according to one of the previous claims, **characterized by** assigning the second parameter to the first parameter in a first iteration, determining the rate for changing the first parameter in the iteration depending on the third parameter, and changing the first parameter in the first iteration and/or a second iteration after the first iteration with the rate.

13. A device for machine learning a model, **characterized in that** the device is configured to perform steps in the method according to one of the claims 1 to 12.

14. A computer program, **characterized in that** the computer program comprises computer readable instructions, that cause a computer to perform steps in the method according to one of the claims 1 to 12 when the instructions are executed by the computer.

Fig. 1

EP 3 975 063 A1

Fig. 2

Fig. 3

Europäisches Patentamt

European Patent Office

Office européen des brevets

# EUROPEAN SEARCH REPORT

Application Number

EP 20 19 8329

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RUITU XU ET AL: "Meta Learning in the Continuous Time Limit", ARXIV.ORG, CORNELL UNIVERSITY LIBRARY, 201 OLIN LIBRARY CORNELL UNIVERSITY ITHACA, NY 14853, 8 July 2020 (2020-07-08), XP081712218, * the whole document * | 1-14 | INV. G06N3/08 G06N20/00 |
| X | DANIEL JIWOONG IM ET AL: "Model-Agnostic Meta-Learning using Runge-Kutta Methods", ARXIV.ORG, CORNELL UNIVERSITY LIBRARY, 201 OLIN LIBRARY CORNELL UNIVERSITY ITHACA, NY 14853, 16 October 2019 (2019-10-16), XP081516498, * the whole document * | 1-14 | |
| A,D | Chelsea Finn ET AL: "Model-Agnostic Meta-Learning for Fast Adaptation of Deep Networks", , 18 July 2017 (2017-07-18), XP055484442, Retrieved from the Internet: URL:https://arxiv.org/pdf/1703.03400.pdf [retrieved on 2018-06-14] * abstract; figure 1 * * sections 1 and 2 * | 1-14 | |
| A | KELLMAN MICHAEL ET AL: "Memory-Efficient Learning for Large-Scale Computational Imaging", IEEE TRANSACTIONS ON COMPUTATIONAL IMAGING, IEEE, vol. 6, 22 September 2020 (2020-09-22), pages 1403-1414, XP011814462, ISSN: 2573-0436, DOI: 10.1109/TCI.2020.3025735 [retrieved on 2020-10-12] * paragraph bridging pages 1403 and 1404 * | 1-14 | TECHNICAL FIELDS SEARCHED (IPC)  G06N |

The present search report has been drawn up for all claims

| Place of search | Date of completion of the search | Examiner |
|---|---|---|
| Munich | 12 April 2021 | Kopilovic, Ivan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)